# EUROPÄISCHE PATENTSCHRIFT

(11) **EP 3 942 541 B1**
(45) Veröffentlichungstag und Bekanntmachung des Hinweises auf die Patenterteilung: **10.05.2023**
(21) Anmeldenummer: 20712337.3
(22) Anmeldetag: 18.03.2020
(51) Int. Cl.: G08B 25/14

(54) **TRÄGERKOMPONENTE EINES GEHÄUSES EINER GEFAHRENMELDERZENTRALE UND EINE GEFAHRENMELDERZENTRALE, VORZUGSWEISE EINER EINBRUCH-, BRANDMELDER- UND/ODER LÖSCHSTEUERZENTRALE**
SUPPORT COMPONENT OF A HOUSING OF A HAZARD ALERT CENTRE AND A HAZARD ALERT CENTRE, PREFERABLY AN INTRUDER ALERT, FIRE ALARM AND/OR EXTINGUISHING CONTROL CENTRE
COMPOSANT PORTEUR D'UN BOÎTIER D'UNE CENTRALE D'ALARME DE DANGERS ET CENTRALE D'ALARME DE DANGERS, DE PRÉFÉRENCE D'UNE CENTRALE D'ALARME D'INFRACTION, D'INCENDIE ET/OU D'UNE CENTRALE DE COMMANDE D'EXTINCTION

(30) Priorität: 18.03.2019 DE 102019106868
(43) Veröffentlichungstag der Anmeldung: 26.01.2022
(73) Patentinhaber: Minimax Viking Research & Development GmbH, 23840 Bad Oldesloe (DE)
(72) Erfinder: DECHAU, Carl, 23840 Bad Oldesloe (DE)
(74) Vertreter: Eisenführ Speiser
(86) Internationale Anmeldenummer: PCT/EP2020/057413
(87) Internationale Veröffentlichungsnummer: WO 2020/187974

(56) Entgegenhaltungen:
- EP-A2- 0 158 795
- DE-A1- 4 418 978
- US-A1- 2012 062 211
- N G Uponor ET AL: "U P O N O R", , 31. Dezember 2008 (2008-12-31), Seiten 1-34, XP055694410, Gefunden im Internet: URL:https://www.uponor.de/UponorInternet/D irectDownload?did=12DC7D8E6CAF48F7A81DDAB6 EBF48DFA [gefunden am 2020-05-12]

## Beschreibung

Die Erfindung betrifft eine Trägerkomponente eines Gehäuses einer Gefahrenmelderzentrale, vorzugsweise einer Einbruch-, Brandmelder- und/oder Löschsteuerzentrale, ein Bedienfeldmodul einer Gefahrenmelderzentrale, eine Anzeige- und Bedienfeldanordnung einer Gefahrenmelderzentrale, ein Gehäuse einer Gefahrenmelderzentrale und eine Gefahrenmelderzentrale.

Gefahrenmelderzentralen wie beispielsweise Einbruch-, Brandmelder- und/oder Löschsteuerzentralen sind aus dem Stand der Technik bekannt. Die EP 2 703 917 A1 beschreibt beispielsweise einen Schaltschrank für Elektrosprinklerpumpen. Die DE 10 2017 107 129 A1 offenbart ein Gehäuse einer Brandmelder- und/oder Löschsteuerzentrale. Gefahrenmelderzentralen weisen in der Regel eine Mehrzahl an Komponenten auf, die innerhalb eines Gehäuses angeordnet sind. Das Gehäuse einer Gefahrenmelderzentrale ist an einem Ort installiert, der auch in einem Alarmfall von autorisiertem Personal betreten werden kann.

Gefahrenmelderzentralen weisen üblicherweise eine Anzeige- und Bedienkomponente auf. An einer solchen Anzeige- und Bedienkomponente können beispielsweise Konfigurationen vorgenommen werden und/oder eine Zuordnung von Störungen oder Alarmen zu einem zugehörigen Melder vorgenommen werden.

Eine Anzeige- und Bedienkomponente kann im Inneren des Gehäuses der Gefahrenmelderzentrale angeordnet sein. Eine derartige Anordnung hat den Nachteil, dass eine schnelle Identifizierung beispielsweise eines Alarmortes oder eines Brandortes verhindert oder erschwert wird, da Einsatzkräfte zunächst das Gehäuse öffnen müssen, bevor Sie den Ort mittels der Anzeige- und Bedienkomponente bestimmen können.

Ferner besteht die Möglichkeit, dass Anzeige- und Bedienkomponenten an einer von au-ßen zugänglichen Seite des Gehäuses angeordnet sind. Eine derartig angeordnete Anzeige- und Bedienkomponente hat in der Praxis mehrere Nachteile hinsichtlich der Einrichtung, Inbetriebnahme und Wartung.

Die Anzeige- und Bedienkomponente weist üblicherweise eine Leiterplatte auf, die notwendige Funktionen und Schaltungselemente aufweist, die zur Ausführung der Bedienung und Anzeige notwendig sind. Leiterplatten zeichnen sich dadurch aus, dass diese empfindlich gegen Erschütterungen und anderweitige Belastungen sind. Leiterplatten sind in der Regel mit Schrauben an der Anzeige- und Bedienkomponente befestigt. Das Anschrauben und Bewegen der Leiterplatte führt regelmäßig zu Schäden, weswegen die Leiterplatte und auch eine diese umgebende Vorrichtung robust ausgebildet werden muss. Darüber hinaus weisen Anzeige- und Bedienkomponenten eine Vielzahl an Beschriftungen auf. Die Beschriftungen weisen beispielsweise auf den Ort einer Meldung hin. Solche Beschriftungen ändern sich in der Regel über die Zeit. Dies begründet sich unter anderem mit sich ändernden normativen Vorgaben. Ferner können sich die Bezeichnungen der Orte, für die eine Gefahrenmelderzentrale zuständig ist, ändern. Derartige Beschriftungen werden oftmals auf Papier gedruckt und in einen Träger eingeschoben.

Das Deutsche Patent- und Markenamt hat in der Prioritätsanmeldung zu vorliegender Anmeldung folgenden Stand der Technik recherchiert: DE 197 44 662 C1, DE 10 2017 108 751 A1, EP 0 841 673 A2 und DE 298 19 414 U1.

N G Uponor et al.: "UPONOR", 31. Dezember 2008 (2008-21-31), Seiten 1-34, XP055694410 offenbart ein Schaltmodul für ein Regelgerät für eine Heiz-/Kühleinrichtung. Das Regelgerät umfasst einen kastenförmigen durch einen Deckel verschließbaren Grundkörper. Innerhalb des Grundkörpers ist über Rasten das Schaltmodul angeordnet, das Anschlüsse für damit zu verbindende Leitungen und Taster zum Einstellen des Regelgerätes aufweist.

Vor diesem Hintergrund ist es eine Aufgabe der vorliegenden Erfindung, eine Trägerkomponente eines Gehäuses einer Gefahrenmelderzentrale, vorzugsweise einer Einbruch-, Brandmelder- und/oder Löschsteuerzentrale, ein Bedienfeldmodul einer Gefahrenmelderzentrale, eine Anzeige- und Bedienfeldanordnung einer Gefahrenmelderzentrale, ein Gehäuse einer Gefahrenmelderzentrale und eine Gefahrenmelderzentrale bereitzustellen, welche einen oder mehrere der genannten Nachteile vermindern oder beseitigen. Ferner ist es eine Aufgabe der Erfindung, eine Lösung bereitzustellen, die eine einfachere Wartung einer Gefahrenmelderzentrale, wie beispielsweise einer Einbruch-, Brandmelder- und/oder Löschsteuerzentrale, ermöglicht. Ferner ist es eine Aufgabe der vorliegenden Erfindung, eine robuster ausgebildete Gefahrenmelderzentrale zu ermöglichen. Insbesondere ist es eine Aufgabe der Erfindung, eine Lösung bereitzustellen, die eine Leiterplatte einer Gefahrenmelderzentrale vor Beschädigungen durch äußere Krafteinwirkungen, insbesondere durch ein Durchbiegen, schützt. Ferner ist es eine Aufgabe der Erfindung, eine Lösung bereitzustellen, die eine Leiterplatte einer Gefahrenmelderzentrale vor elektrostatischen Entladungen (ESD) schützt. Die Erfindung wird durch die Merkmale des Hauptanspruchs 1 definiert.

Gemäß einem ersten Aspekt der Erfindung wird die eingangs genannte Aufgabe gelöst durch eine Trägerkomponente eines Gehäuses einer Gefahrenmelderzentrale, vorzugsweise einer Einbruch-, Brandmelder- und/oder Löschsteuerzentrale, umfassend: erste Rastmittel zum einrastenden Verbinden der Trägerkomponente mit einem auf einer Innenseite einer Wand des Gehäuses angeordneten Halterahmen, wobei die ersten Rastmittel derart angeordnet sind, dass eine Vorderseite der Trägerkomponente in einem eingerasteten Zustand der Innenseite der Wand des Gehäuses zugewandt ist, zweite Rastmittel zum einrastenden Verbinden mit einer Leiterplatte, wobei die Leiterplatte im eingerasteten Zustand auf einer der Vorderseite gegenüberliegenden Rückseite der Trägerkomponente angeordnet ist, einen Betätigungsbereich, der wenigstens ein Betätigungselement aufweist, das dazu ausgebildet ist, durch Krafteinwirkung aus einer Ausgangsstellung in Richtung der Rückseite verformt zu werden, um eine Betätigungskraft auf die Leiterplatte zu übertragen, wobei das Betätigungselement bei Beendigung der Krafteinwirkung in die Ausgangsstellung zurückkehrt.

Die Trägerkomponente umfasst die ersten Rastmittel, die zweiten Rastmittel, den Betätigungsbereich und den Anzeigebereich. Die ersten Rastmittel sind eingerichtet, die Trägerkomponente an einem Gehäuse anzuordnen und/oder zu befestigen. Ferner können die Rastmittel derart eingerichtet sein, dass diese an einem Halterahmen eines Gehäuses einer Gefahrenmelderzentrale einrasten. Die einrastende Wirkung der ersten Rastmittel kann derart verstanden werden, dass eine ineinandergreifende Verbindung gebildet wird. Diese ineinandergreifende Verbindung kann beispielsweise durch ein Ankoppeln, ein Einhaken, ein Sicheinhängen, ein Einschnappen, ein Einspringen und/oder ein Zuschnappen erfolgen.

Die Trägerkomponente weist eine Vorderseite und eine Rückseite auf. Die Vorderseite der Trägerkomponente ist im bestimmungsgemäßen Betrieb einer Innenseite der Wand des Gehäuses der Gefahrenmelderzentrale zugewandt. Ferner ist die Vorderseite der Trägerkomponente derart ausgebildet, dass diese im bestimmungsgemäß eingerasteten Zustand an der Innenseite der Wand des Gehäuses von einer Außenseite der Wand des Gehäuses zugänglich ist, beispielsweise durch Öffnungen in der Wand des Gehäuses. Vorzugsweise ist die Vorderseite der Trägerkomponente von einer Außenseite der Wand aus sichtbar und/oder betätigbar angeordnet.

Die zweiten Rastmittel sind angeordnet und ausgebildet, dass mittels dieser eine Leiterplatte an der Rückseite der Trägerkomponente anordenbar und befestigbar ist. Die Rückseite der Trägerkomponente ist derart ausgebildet, dass an dieser eine Leiterplatte anordenbar ist. Die Rückseite der Trägerkomponente weist einen Leiterplattenabschnitt auf, in dem eine Leiterplatte bevorzugt anordenbar ist. Die zweiten Rastmittel sind an der Trägerkomponente derart angeordnet, dass diese eine Leiterplatte an der Rückseite der Trägerkomponente an dem Leiterplattenbereich mit der Trägerkomponente koppeln können. Die zweiten Rastmittel sind von den ersten Rastmitteln verschieden. Vorzugsweise sind die ersten Rastmittel an zwei gegenüberliegenden Seiten der Trägerkomponente angeordnet. Ferner vorzugsweise sind die zweiten Rastmittel an zwei gegenüberliegenden Seiten angeordnet, die von den Seiten der ersten Rastmittel verschieden sind. Ferner können die Seiten, an denen die ersten Rastmittel angeordnet sind, orthogonal zu den Seiten, an denen die zweiten Rastmittel angeordnet sind, ausgerichtet sein. Außerdem kann die Trägerkomponente einen von der Rückseite auskragenden Kragen aufweisen. Es ist ferner bevorzugt, dass die ersten Rastmittel an einem nach außen gerichteten Abschnitt des Kragens angeordnet sind. Ferner vorzugsweise sind die zweiten Rastmittel an einem nach innen ragenden Abschnitt des Kragens angeordnet.

Der Betätigungsbereich weist das wenigstens eine Betätigungselement auf. Das Betätigungselement ist ausgebildet, durch Krafteinwirkung aus einer Ausgangsstellung in Richtung der Rückseite verformt zu werden. Dies bedeutet, dass das Betätigungselement durch die Krafteinwirkung in eine Betätigungsrichtung bewegt wird, wobei die Betätigungsrichtung von der Außenseite zur Innenseite ausgerichtet ist. Das Betätigungselement ist derart in Richtung der Betätigungsrichtung bewegbar, dass das Betätigungselement von der Ausgangsstellung derart in eine Betätigungsstellung bewegt werden kann, dass die Betätigungskraft in der Betätigungsstellung auf eine an der Rückseite der Trägerkomponente angeordnete Leiterplatte übertragbar ist. Die Rückkehr des Betätigungselements von der Betätigungsstellung in die Ausgangsstellung erfolgt beispielsweise durch eine Federwirkung. Das Betätigungselement ist vorzugsweise derart am Betätigungsbereich angeordnet, dass die Federwirkung bereits durch die Anordnung selbst erfolgt. Alternativ kann die Federwirkung durch ein zusätzliches Element, beispielsweise ein Federelement, ermöglicht werden.

Der vorliegenden Erfindung liegt die Erkenntnis zugrunde, dass bestehende Gefahrenmelderzentralen oftmals eine eingeschränkte Wartbarkeit aufweisen. Ferner liegt der Erfindung die Erkenntnis zugrunde, dass die Wartung von Gefahrenmelderzentralen oftmals mit einem hohen Aufwand verbunden ist. Die im Vorherigen beschriebene Trägerkomponente eines Gehäuses einer Gefahrenmelderzentrale ermöglicht beispielsweise das einhändige und insbesondere werkzeugfreie Auswechseln der Trägerkomponente mit einer an dieser angeordneten Leiterplatte. Aufgrund dessen besteht die Möglichkeit für einen Monteur, mit einer Hand die Trägerkomponente zu entrasten und zu bewegen und mit der anderen Hand eine Wartungstätigkeit durchzuführen. Beispielsweise können Beschriftungen zwischen der Trägerkomponente und dem Gehäuse ausgetauscht werden. Ein Wartungsmonteur kann beispielsweise mit einer Hand die Trägerkomponente von dem Gehäuse lösen und mit der anderen Hand ein Beschriftungselement zwischen der Trägerkomponente und dem Gehäuse austauschen. Beschriftungen an Gefahrenmelderzentralen sind während der Lebensdauer einer solchen auszutauschen. Beispielsweise kann die Sprache gewechselt werden.

Darüber hinaus wird die Leiterplatte bei Wartungstätigkeiten nicht unmittelbar berührt, wodurch sich der Schutz vor elektrostatischen Entladungen erhöht. Die in der Regel sensiblen Leiterplatten sind an der Trägerkomponente angeordnet und können mitsamt der Trägerkomponente von dem Gehäuse entfernt werden. Infolge dessen wird die Leiterplatte weniger belastet. Darüber hinaus steigert die im Vorherigen beschriebene Trägerkomponente die Möglichkeit eines modularen Aufbaus. Des Weiteren ermöglicht die Trägerkomponente die effiziente Montage, da die Trägerkomponente mit einer in dieser angeordneten Leiterplatte als Modul montierbar ist und erst später als Modul in der Gefahrenmelderzentrale anordenbar ist.

Des Weiteren ist auch die Trägerkomponente an sich durch die ersten Rastmittel derart schnell und einfach von dem Gehäuse austauschbar, dass der Wartungs- und Montageaufwand reduziert ist. Ein Schrauben ist beispielsweise nicht erforderlich.

In einer bevorzugten Ausführungsvariante der Trägerkomponente ist vorgesehen, dass diese einen Anzeigebereich umfasst, der wenigstens einen Lichtdurchgang aufweist, der dazu ausgebildet ist, ein optisches Signal der Leiterplatte zu der Vorderseite der Trägerkomponente hindurchzuführen. Der Anzeigebereich weist den wenigstens einen Lichtdurchgang auf. Der Lichtdurchgang ist dazu ausgebildet, ein optisches Signal der Leiterplatte zu der Vorderseite der Trägerkomponente hindurchzuführen. Der Lichtdurchgang kann beispielsweise als eine Aussparung in der Trägerkomponente vorgesehen sein. Alternativ kann der Lichtdurchgang durch ein transparentes Material ermöglicht werden. Darüber hinaus kann der Lichtdurchgang durch eine Auskopplung eines Lichtleiters ausgebildet werden.

In einer bevorzugten Ausführungsvariante der Trägerkomponente ist vorgesehen, dass diese Führungsmittel zum Führen eines austauschbaren Beschriftungselementes, vorzugsweise eines als Papier oder Folie ausgebildeten Schildes, aufweist, wobei die Führungsmittel auf der Vorderseite der Trägerkomponente angeordnet sind, derart, dass das Beschriftungselement in einem eingerasteten Zustand der ersten Rastmittel zwischen der Trägerkomponente und der Gehäusewand angeordnet ist.

Das Beschriftungselement ist vorzugsweise derart angeordnet, dass dieses von einer Außenseite des Gehäuses aus sichtbar ist. Die Führungsmittel der Trägerkomponente richten das Beschriftungselement vorzugsweise in einer vordefinierten Position aus. Die Führungsmittel bilden vorzugsweise mit einem Beschriftungselement einen Beschriftungsbereich aus. Der Beschriftungsbereich umfasst vorzugsweise verschiedene Beschriftungselemente. Ein Beschriftungselement ist vorzugsweise an einem Betätigungselement angeordnet und/oder zu einem Betätigungselement benachbart angeordnet.

Die Führungsmittel ermöglichen die Anordnung eines Beschriftungselements in einer vordefinierten Position, sodass keine oder verminderte zusätzliche Ausrichtungsaufwände erforderlich sind. Aufgrund der ersten Rastmittel der Trägerkomponente kann diese wie im Vorherigen bereits erläutert mittels geringem Aufwand von dem Gehäuse getrennt werden. In Kombination mit den Führungsmitteln kann das Beschriftungselement mit geringem Aufwand ausgetauscht werden. Die Führungsmittel weisen hierfür vorzugsweise eine horizontale Führung auf. Darüber hinaus weisen die Führungsmittel vorzugsweise eine vertikale Führung auf. Die Führungsmittel können vertikale Anschläge und/oder horizontale Anschläge aufweisen.

In einerweiteren bevorzugten Ausführungsvariante der Trägerkomponente ist vorgesehen, dass die Trägerkomponente einstückig ausgebildet ist. Die einstückige Ausbildung der Trägerkomponente reduziert weiter den Montageaufwand des Gehäuses der Gefahrenmelderzentrale. Darüber hinaus ermöglicht die einstückige Ausbildung der Trägerkomponente eine effiziente Fertigung durch Formverfahren. Des Weiteren ist es bevorzugt, dass die Trägerkomponente Kunststoff aufweist oder aus Kunststoff besteht und vorzugsweise im Spritzgussverfahren hergestellt ist.

Die Trägerkomponente ist individuell in einer Vielzahl auch unterschiedlicher Gefahrenmelderzentralen einsetzbar. Aufgrund dessen ist die Montage von einer hohen Anzahl von Trägerkomponenten erforderlich. Aufgrund dessen ist die Trägerkomponente vorzugsweise derart ausgebildet, dass diese im Spritzgussverfahren herstellbar ist. Ferner ist die Ausbildung dieser aus Kunststoff kostengünstig. Darüber hinaus besteht die Möglichkeit einer Ausbildung des Betätigungselements aus Kunststoff, sodass ohne weitere Komponenten die im Vorherigen genannte Federwirkung ermöglicht wird.

Eine weitere bevorzugte Fortbildung der Trägerkomponente zeichnet sich dadurch aus, dass die Führungsmittel eine Führung des Beschriftungselementes in der gleichen Richtung ermöglichen, in der das Einrasten mittels der ersten Rastmittel erfolgt. Darüber hinaus ist es bevorzugt, dass die ersten Rastmittel eine an einer unteren Seite der Trägerkomponente ausgebildete Feder und einen an der oberen Seite der Trägerkomponente ausgebildeten Rastfinger, der eine nach außen gerichtete Rastnase aufweist, umfasst.

Der Rastfinger ist vorzugsweise derart ausgebildet, dass dieser wenigstens teilweise in einer Öffnung des Halterahmens anordenbar ist. Vorzugsweise weist der Rastfinger eine Rastnase auf, die in der Öffnung des Halterahmens anordenbar ist. Aufgrund der Anordnung des Rastfingers in einer solchen Öffnung ist eine Fixierung der Trägerkomponente ermöglicht. Durch die an der der oberen Seite gegenüberliegenden unteren Seite angeordnete Feder kann die Trägerkomponente an dieser unteren Seite ebenfalls mit dem Gehäuse, vorzugsweise dem Halterahmen, verbunden werden. Die Feder ist vorzugsweise derart ausgebildet, dass diese eine Rastverbindung ausbilden kann. Beispielsweise kann eine Länge des Rastfingers derart ausgeführt ist, dass der Rastfinger in dem eingerasteten Zustand über eine Höhe des Halterahmens hinausragt, wodurch eine gute Bewegbarkeit des Rastfingers für einen Monteur ermöglicht wird.

Darüber hinaus ist es bevorzugt, dass der Rastfinger des ersten Rastmittels derart ausgebildet ist, dass ein einhändiges und werkzeugfreies Lösen der Rastverbindung möglich ist. Darüber hinaus ist es bevorzugt, dass die Rastverbindung des ersten Rastmittels durch ein Schwenken um eine Achse, die durch die Feder definiert ist, erfolgt. Vorzugsweise ist die Feder derart ausgebildet, dass ein Schwenken um einen bestimmten Winkel ermöglicht wird. Ferner vorzugsweise umfasst die Trägerkomponente je zwei Federn an der unteren Seite und je zwei Rastfinger an der oberen Seite.

In einerweiteren bevorzugten Ausführungsvariante der Trägerkomponente ist vorgesehen, dass die zweiten Rastmittel gegenüberliegend angeordnete, an inneren Seitenflächen der Trägerkomponente ausgebildete, vorzugsweise je zwei an einer linken und rechten Seitenfläche ausgebildete, Rastnasen aufweisen. Die inneren Seitenflächen sind vorzugsweise durch den Kragen ausgebildet. Die Rastnasen sind ferner vorzugsweise als elastisch vorspringende Elemente ausgebildet. Vorzugsweise ist die Schwenkachse der Rastnasen orthogonal zu einer Schwenkachse der Rastfinger der ersten Rastmittel.

Darüber hinaus ist es bevorzugt, dass an den inneren Seitenflächen ein Fixierungselement zur horizontalen Fixierung der in den zweiten Rastmitteln eingerasteten Leiterplatte angeordnet ist. Das Fixierungselement ist vorzugsweise plastisch verformbar. Die plastische Verformung ist irreversibel. Die plastische Verformung des Fixierungselementes erfolgt vorzugsweise bei Anordnung der Leiterplatte an der Trägerkomponente und vorzugsweise beim, vor oder nach Einrasten mit den zweiten Rastmitteln. Durch ein derartiges Fixierungselement kann eine Leiterplatte spielfrei an der Trägerkomponente angeordnet werden. Die Leiterplatte ist somit robuster an der Trägerkomponente angeordnet und das Risiko von die Leiterplatte beschädigenden Schwingungen reduziert. Darüber hinaus ist durch ein zuvor genanntes Fixierungselement ein durch Spiel verursachtes Geräusch vermieden. Außerdem vermindert sich das Risiko einer mechanischen Beschädigung beim Einbau durch Verbiegen, insbesondere bei der Nutzung eines Steckverbinders, oder durch Verspannen, insbesondere bei der Fixierung einer Leiterplatte mittels Schrauben.

Darüber hinaus ist es bevorzugt, dass die Trägerkomponente eine Aufnahme für ein Distanzelement aufweist. Die Aufnahme für das Distanzelement ist vorzugsweise an der Rückseite der Trägerkomponente angeordnet. In einer einfachen Ausführung des Distanzelements ist dieses als Positionierungshilfe ausgebildet. In der Aufnahme können beispielsweise Elastomere angeordnet werden, vorzugsweise geklebt werden, um eine Vorspannung zwischen der Rückseite der Trägerkomponente und einer an dieser zu befestigenden Leiterplatte einzurichten, sodass Geräusche vermieden oder vermindert werden. Das Distanzelement kann beispielsweise kegelförmig ausgebildet sein.

Darüber hinaus ist es bevorzugt, dass der Betätigungsbereich mehrere Betätigungselemente, vorzugsweise mehrere in zwei Spalten angeordnete Betätigungselemente, aufweist, und wobei eins, zwei oder mehrere oder jedes der Betätigungselemente wenigstens einen zugehörigen Lichtdurchgang aufweist. Der wenigstens eine zugehörige Lichtdurchgang kann beispielsweise im Betriebszustand derart angeordnet sein, dass eine Diode einer Leiterplatte hinter diesem wenigstens einen zugehörigen Lichtdurchgang angeordnet ist. Ferner ist es bevorzugt, dass ein, zwei oder mehrere oder jedes der Betätigungselemente zwei zugehörige Lichtdurchgänge aufweist.

Vorzugsweise ist der oder einer der Lichtdurchgänge seitlich neben einem Betätigungselement angeordnet. Ferner vorzugsweise bilden die zwei zugehörigen Lichtdurchgänge ein Lichtmodul, das seitlich neben einem Betätigungselement angeordnet ist. Ferner ist es bevorzugt, dass ein oder beide Lichtdurchgänge ein Farbelement aufweisen. Das Farbelement ist beispielsweise zumindest teilweise lichtdurchlässig ausgebildet. Das Farbelement kann als ein farblich gefärbtes Glas, vorzugsweise ein Plexiglas, ausgebildet sein. Darüber hinaus ist es bevorzugt, dass dieses ein rotes und/oder gelbes Licht ermöglicht. Ein rotes Licht kann beispielsweise bei Gefahrenmelderzentralen für ein Feuer und gelb für eine Störung emittiert werden.

Eine weitere bevorzugte Fortbildung der Trägerkomponente sieht vor, dass das Betätigungselement einen Halsabschnitt und einen sich daran anschließenden Druckabschnitt mit größerem Querschnitt aufweist, wobei sich der Halsabschnitt bei Druckausübung auf den Druckabschnitt elastisch verformt.

Der Halsabschnitt verbindet vorzugsweise den Druckabschnitt mit der übrigen Trägerkomponente. Vorzugsweise weist der Druckabschnitt einen kreisrunden Querschnitt auf. Der Druckabschnitt weist vorzugsweise einen Spalt zu der übrigen Trägerkomponente auf. Der Halsabschnitt, der den Druckabschnitt mit der übrigen Trägerkomponente verbindet, ist vorzugsweise derart angeordnet und ausgebildet, dass der Druckabschnitt gedrückt werden kann und somit von einer Ausgangsstellung zu einer Betätigungsstellung bewegbar ist. Der Halsabschnitt ist vorzugsweise als schlanker Abschnitt ausgebildet. Der Halsabschnitt kann in den Druckabschnitt übergehen. Darüber hinaus ist es bevorzugt, dass der Druckabschnitt eine gewölbte, vorzugsweise in Richtung der Vorderseite konvex gewölbte, Form aufweist.

In einer weiteren bevorzugten Fortbildung der Trägerkomponente ist vorgesehen, dass die Führungsmittel mehrere, im Wesentlichen parallel zu der Vorderseite der Trägerkomponente angeordnete Führungsnasen aufweisen, wobei wenigstens eine der Führungsnasen einen Anschlag entgegen der Führungsrichtung definiert, und vorzugsweise eine Unterseite wenigstens einer Führungsnase in horizontaler Richtung eine geringere Beabstandung von der Rückseite aufweist als die Vorderseite von der Rückseite. Eine derartige Anordnung kann zu einer Vorspannung des Beschriftungselementes führen.

Die Führungsnasen sind alternativ vorzugsweise in vertikaler Richtung von der Vorderseite derart beabstandet, dass zwischen einer Unterseite der Führungsnasen und der Vorderseite eine lichte Höhe herrscht. Die lichte Höhe ist vorzugsweise derart gewählt, dass zwischen der Unterseite der Führungsnase und der Vorderseite ein Beschriftungselement anordenbar ist. Ferner ist es bevorzugt, dass die Trägerkomponente eine Aussparung für ein an der Leiterplatte angeordnetes Display aufweist. Die Trägerkomponente weist vorzugsweise eine Abmessung in vertikaler Richtung von größer 5 cm, größer 10 cm, größer 15 cm, größer 20 cm oder größer 25 cm auf. Insbesondere ist es bevorzugt, dass die Trägerkomponente eine Abmessung in vertikaler Richtung zwischen 17 cm und 18 cm aufweist. Die horizontale Abmessung in Richtung der Breite ist vorzugsweise größer 5 cm, größer 7,5 cm oder größer 10 cm, wobei ein Bereich zwischen 8 cm und 9 cm besonders bevorzugt ist Der Kragen kragt vorzugsweise mehr als 0,5 cm, mehr als 1cm, mehr als 1,5 cm, mehr als 2 cm oder mehr als 3 cm aus, wobei es insbesondere bevorzugt ist, dass der Kragen zwischen 27 cm und 28 cm auskragt.

Gemäß einem weiteren Aspekt der Erfindung wird die eingangs genannte Aufgabe gelöst durch ein Bedienfeldmodul einer Gefahrenmelderzentrale, umfassend eine Trägerkomponente nach einer der vorstehenden Ausführungsvarianten und eine in die zweiten Rastmittel eingerastete Leiterplatte.

Das Bedienfeldmodul ist somit eine vormontierbare Baueinheit, die in einem Gehäuse einer Gefahrenmelderzentrale angeordnet werden kann. Die Leiterplatte ist vorzugsweise an der Rückseite der Trägerkomponente angeordnet. Ferner vorzugsweise ist die Leiterplatte von einem Kragen der Trägerkomponente umgeben, wobei es bevorzugt ist, dass die zweiten Rastmittel an dem Kragen verortet sind und die zweiten Rastmittel von dort aus die Leiterplatte halten. Ferner vorzugsweise ist zwischen der Leiterplatte und der Rückseite der Trägerkomponente ein Distanzelement angeordnet, das etwaiges Spiel zwischen der Leiterplatte und der Rückseite der Trägerkomponente ausgleicht bzw. vermindert. Des Weiteren ist es bevorzugt, dass die Leiterplatte in vertikaler Richtung und in seitlicher horizontaler Richtung durch Fixierungselemente spielfrei angeordnet ist. Derartige Fixierungselemente ermöglichen eine einfache Ausbildung der zweiten Rastmittel, da diese nicht zwingend dafür ausgebildet sein müssen, die Leiterplatte spielfrei zu fixieren.

Die Leiterplatte umfasst vorzugsweise wenigstens ein druckempfindliches Element, das zur Erzeugung eines elektrischen Signals ausgebildet ist. Das wenigstens eine druckempfindliche Element ist vorzugsweise derart an der Leiterplatte angeordnet, dass dieses durch die Betätigungskraft des Betätigungselements betätigt wird und das elektrische Signal erzeugt.

Gemäß einem weiteren Aspekt der vorliegenden Erfindung wird die eingangs genannte Aufgabe gelöst durch eine Anzeige- und Bedienfeldanordnung einer Gefahrenmelderzentrale, umfassend: ein Anzeige- und Bedienfeld, einen Halterahmen, und wenigstens ein Bedienfeldmodul nach dem vorherigen Aspekt.

In einer bevorzugten Fortbildung ist vorgesehen, dass das Anzeige- und Bedienfeld eine Folie aufweist, wobei die Folie auf einer Vorderseite oder einer Hinterseite des Anzeige- und Bedienfelds angeordnet ist. Die Folie kann auf das Anzeige- und Bedienfeld geklebt sein. Die Folie weist vorzugsweise Symbole zur Kennzeichnung von Anzeige- und Bedienelementen auf. Eine derartige Folie hat den Vorteil, dass bei vollständiger Funktion der Bedienelemente ein Eindringen von Schmutz in das Anzeige- und Bedienfeld verhindert oder zumindest vermindert wird. Die Folie hat ferner den Vorteil, dass eine obere Kante des Beschriftungselements zwischen dem Anzeige- und Bedienfeld und der Folie eingeklemmt werden kann.

Das Anzeige- und Bedienfeld kann beispielsweise als Blende ausgebildet sein. Das Anzeige- und Bedienfeld weist vorzugsweise Durchbrüche auf, die derart angeordnet und ausgebildet sind, dass diese einen Zugriff von einer Außenseite des Anzeige- und Bedienfelds auf die Betätigungselemente der Trägerkomponente ermöglichen. Das Anzeige- und Bedienfeld weist ferner auf einer seiner Außenseite abgewandten Innenseite den Halterahmen auf. Der Halterahmen ist derart ausgebildet, dass dieser zu den ersten Rastmitteln korrespondiert, vorzugsweise derart, dass die Trägerkomponente mittels der ersten Rastmittel an dem Halterahmen angeordnet werden kann. Der Halterahmen umfasst vorzugsweise einen ersten Halterahmenabschnitt und einen zweiten Halterahmenabschnitt, die ferner vorzugsweise vertikal beabstandet an dem Anzeige- und Bedienfeld angeordnet sind. Die Trägerkomponente ist vorzugsweise in vertikaler Richtung zwischen dem ersten Halterahmenabschnitt und dem zweiten Halterahmenabschnitt angeordnet. An dem ersten Halterahmenabschnitt und dem zweiten Halterahmenabschnitt sind vorzugsweise mit den ersten Rastmitteln korrespondierende Öffnungen angeordnet.

Ferner ist es bevorzugt, dass der Halterahmen auf einer Innenseite des Anzeige- und Bedienfelds reversibel befestigt, vorzugsweise verschraubt ist, und/oder der Halterahmen eine Durchgangsöffnung zur Anordnung von Befestigungsmitteln für einen Kabelstrang, vorzugsweise Kabelbaum, aufweist.

Dieser Anordnung liegt die Erkenntnis zugrunde, dass Spritzgussteile sich beim Verkleben aneinander verformen. Dadurch ist das Schrauben von einem ersten Spritzgussteil an ein zweites Spritzgussteil vorteilhaft. Der Halterahmen weist vorzugsweise eine erste Position für ein erstes Bedienfeldmodul und eine zweite Position für ein zweites Bedienfeldmodul auf. Zwischen der ersten Position und der zweiten Position ist an dem Halterahmen vorzugsweise eine Öffnung angeordnet. Die Öffnung ist ferner vorzugsweise im Bereich von Schrauben zur Befestigung des Halterahmens an dem Anzeige- und Bedienfeld vorgesehen. Die Öffnung ist vorzugsweise derart angeordnet und ausgebildet, dass durch diese ein Kabelbinder oder ein sonstiges Mittel zur Befestigung eines Kabels geführt werden kann. Mittels dieser Öffnung kann ein Kabelstrang, vorzugsweise ein Kabelbaum, an dem Halterahmen befestigt werden.

Darüber hinaus wird die eingangs genannte Aufgabe gelöst durch ein Gehäuse einer Gefahrenmelderzentrale, umfassend: einen Gehäuseabschnitt mit mindestens einer Anzeige- und Bedienfeldanordnung nach dem im Vorherigen beschriebenen Aspekt.

Vorzugsweise umfasst das Gehäuse eine zweite Leiterplatte, die eine zentrale Rechnereinheit umfasst oder als solche ausgebildet ist. Die zweite Leiterplatte ist vorzugsweise ausgebildet, um eine Anzeige, insbesondere ein Display, und LED-Anzeigen zu steuern.

Ferner wird die eingangs genannte Aufgabe gelöst durch eine Gefahrenmelderzentrale, Brandmelder und/oder Löschsteuerzentrale mit einem Gehäuse nach dem im Vorherigen beschriebenen Aspekt, wobei in jeder der Trägerkomponenten eine zugehörige Leiterplatte eingerastet ist, und Leiterplatten nebeneinander angeordneter Trägerkomponenten direkt mit einem Verbindungskabel zur Datenübertragung verbunden sind.

Die Gefahrenmelderzentrale ist vorzugsweise derart fortgebildet, dass jede der Leiterplatten dazu ausgebildet ist, den Zustand mehrerer signalleitend mit der Gefahrenmelderzentrale verbundenen Peripheriegeräten, vorzugsweise mehrerer Meldergruppen einer Brandmelder- und/oder Löschsteuerzentrale, anzuzeigen. Des Weiteren kann es bevorzugt sein, dass die Bezeichnung der Meldergruppen oder Komponenten mittels der Beschriftungselemente der jeweiligen Trägerkomponenten erfolgt.

Für weitere Vorteile, Ausführungsvarianten und Ausführungsdetails dieser weiteren Aspekte und ihrer möglichen Fortbildungen wird auch auf die zuvor erfolgte Beschreibung zu den entsprechenden Merkmalen und Fortbildungen der Trägerkomponente verwiesen.

Bevorzugte Ausführungsformen der Erfindung werden beispielhaft anhand der beiliegenden Figuren erläutert. Es zeigen:
- Figur 1:: eine schematische, dreidimensionale Ansicht eines Gehäuses einer Gefahrenmelderzentrale;
- Figur 2:: eine schematische, zweidimensionale Teilansicht des Gehäuses;
- Figur 3:: eine schematische Explosionszeichnung einer Anzeige- und Bedienfeldanordnung;
- Figur 4:: eine schematische, dreidimensionale Ansicht der Anzeige- und Bedienfeldanordnungaus Figur 3;
- Figur 5:: eine weitere schematische, dreidimensionale Ansicht der Anzeige- und Bedienfeldanordnungaus Figur 3;
- Figur 6:: eine weitere schematische, dreidimensionale Ansicht der Anzeige- und Bedienfeldanordnungaus Figur 3;
- Figur 7:: eine schematische, dreidimensionale Ansicht der Anzeige- und Bedienfeldanordnungaus Figur 3;
- Figur 8:: eine schematische, dreidimensionale Ansicht eines Bedienfeldmoduls;
- Figur 9:: eine schematische, dreidimensionale Ansicht einer Vorderseite der Trägerkomponente;
- Figur 10:: eine schematische dreidimensionale Ansicht der Vorderseite einer Trägerkomponente;
- Figur 11:: eine schematische, dreidimensionale Ansicht einer Rückseite der Trägerkomponente;
- Figur 12:: eine schematische, dreidimensionale Teilansicht einer Anzeige- und Bedienfeldanordnung; und
- Figur 13:: eine schematische, dreidimensionale Ansicht einerweiteren Anzeige- und Bedienfeldanordnung.

In den Figuren sind gleiche oder im Wesentlichen funktionsgleiche bzw. -ähnliche Elemente mit den gleichen Bezugszeichen bezeichnet.

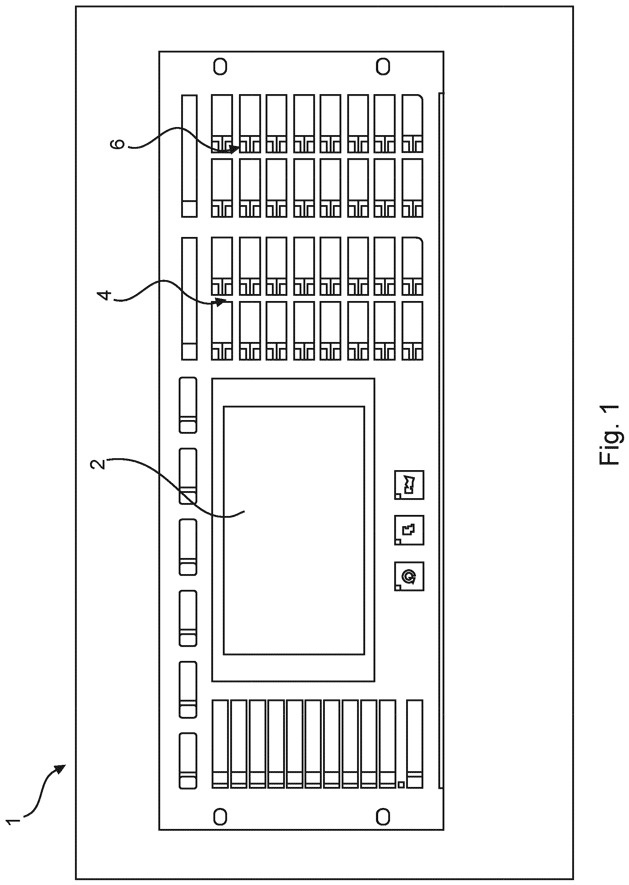

Figur 1 zeigt eine schematische, dreidimensionale Ansicht eines Gehäuses einer Gefahrenmelderzentrale 1. Das Gehäuse der Gefahrenmelderzentrale 1 weist einen Bildschirm 2 auf. Darüber hinaus weist das Gehäuse einen ersten Tastenbereich 4 und einen zweiten Tastenbereich 6 auf. Darüber hinaus kann das Gehäuse weitere Tastenbereiche aufweisen, beispielsweise einen dritten Tastenbereich, einen vierten Tastenbereich, einen fünften Tastenbereich, einen sechsten Tastenbereich und einen siebten Tastenbereich. Hinter diesen Tastenbereichen 4, 6 ist jeweils eine Trägerkomponente angeordnet, wie sie im Folgenden noch näher erläutert wird. Vorzugsweise ist hinter den einzelnen Tasten der Tastenbereiche 4, 6 jeweils ein Betätigungselement der Trägerkomponenten verortet.

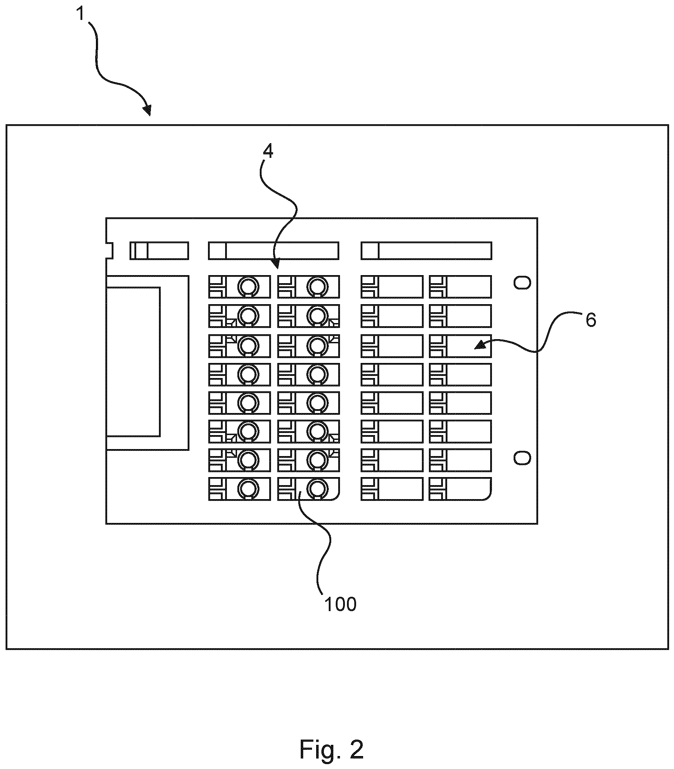

Figur 2 zeigt eine schematische, zweidimensionale Teilansicht der Gefahrenmelderzentrale. Der erste Tastenbereich 4 ist hier gebrochen dargestellt, sodass durch die Aussparungen in dem Gehäuse die hinter dem ersten Tastenbereich 4 angeordnete Trägerkomponente 100 zu erkennen ist. Das hinter jeder Taste angeordnete kreisförmige Element ist ein Betätigungselement der Trägerkomponente 100.

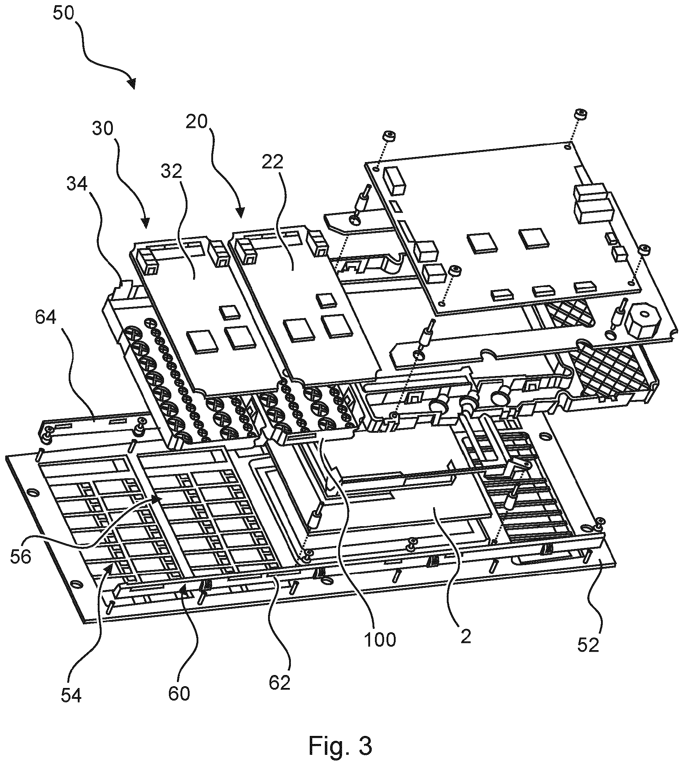

Figur 3 zeigt eine schematische Explosionszeichnung einer Anzeige- und Bedienfeldanordnung. Die Anzeige- und Bedienfeldanordnung 50 umfasst ein Anzeige- und Bedienfeld 52, ein erstes Bedienfeldmodul 20 und ein zweites Bedienfeldmodul 30. Das Anzeige- und Bedienfeld 52 weist ferner einen Halterahmen 60 auf. Der Halterahmen 60 umfasst einen ersten Halterahmenabschnitt 62 und einen zweiten Halterahmenabschnitt 64. Der erste Halterahmenabschnitt 62 ist entlang einer ersten Kante des Anzeige- und Bedienfelds 52 angeordnet. Der zweite Halterahmenabschnitt 64 ist an einer dieser Kante gegenüberliegenden Kante des Anzeige- und Bedienfelds 52 angeordnet. Folglich sind der erste Halterahmenabschnitt 62 und der zweite Halterahmenabschnitt 64 im Wesentlichen parallel zueinander angeordnet. Das Anzeige- und Bedienfeld 52 weist erste Betätigungsöffnungen 54 und zweite Betätigungsöffnungen 56 auf. Die Betätigungsöffnungen 54, 56 sind derart an dem Anzeige- und Bedienfeld 52 angeordnet, dass auf der Rückseite angeordnete Bedienfeldmodule 20, 30 von der Außenseite aus erreichbar sind.

Das erste Bedienfeldmodul 20 umfasst die erste Trägerkomponente 100 und eine erste Leiterplatte 22. Die erste Leiterplatte 22 ist auf einer Rückseite der ersten Trägerkomponente 100 mittels zweiter Rastmittel angeordnet, die im Folgenden noch näher erläutert sind. Das zweite Bedienfeldmodul 30 weist eine zweite Leiterplatte 32 und eine zweite Trägerkomponente 34 auf, wobei die zweite Leiterplatte 32 mit zweiten Rastmitteln an der zweiten Trägerkomponente 34 angeordnet ist. Die Bedienfeldmodule 20, 30 sind mittels im Folgenden noch näher erläuterten ersten Rastmitteln an dem Halterahmen 60 angeordnet.

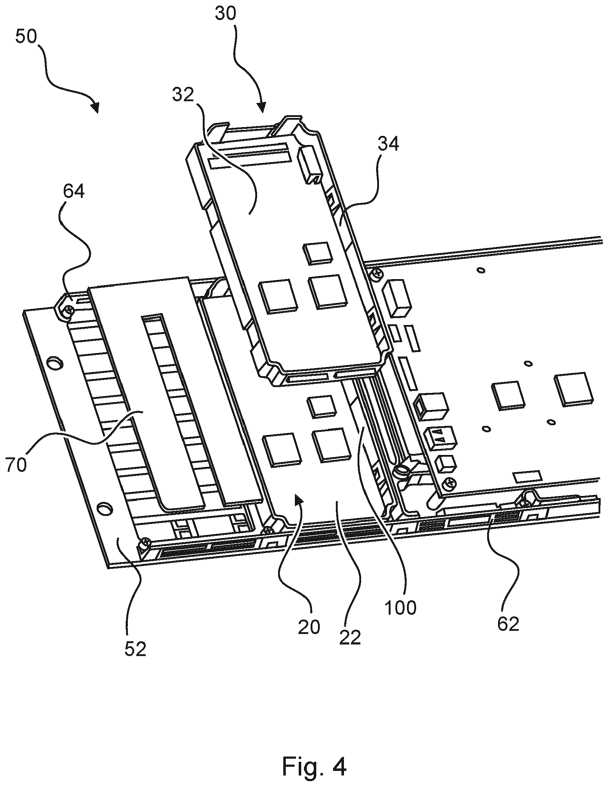

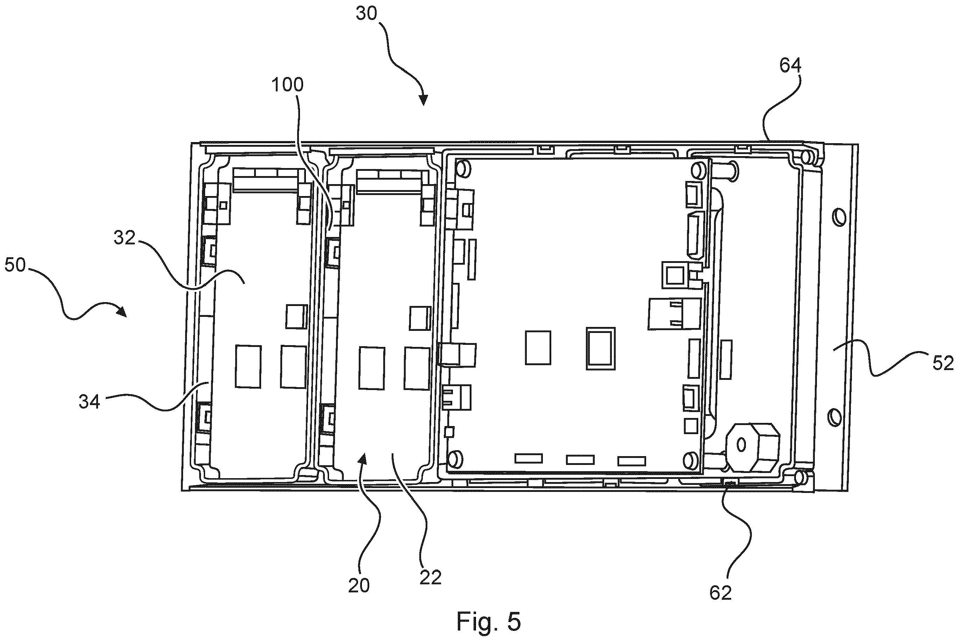

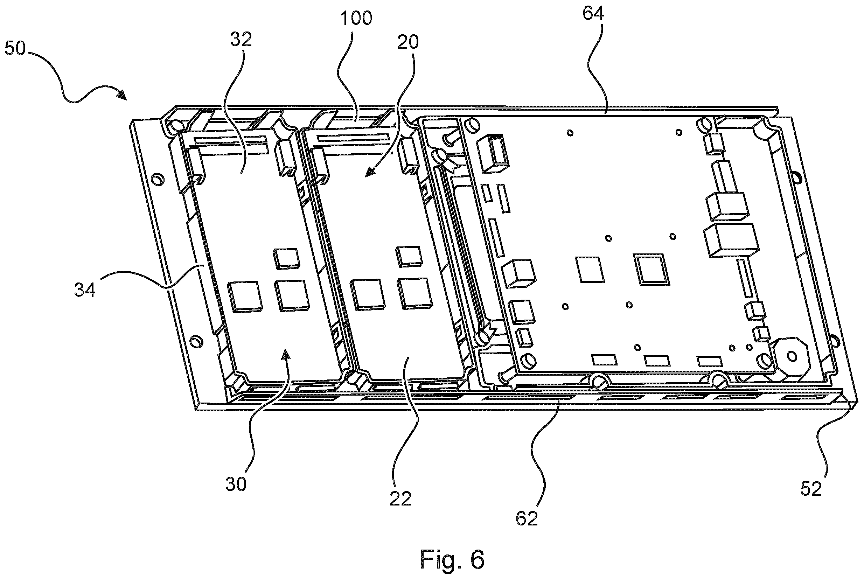

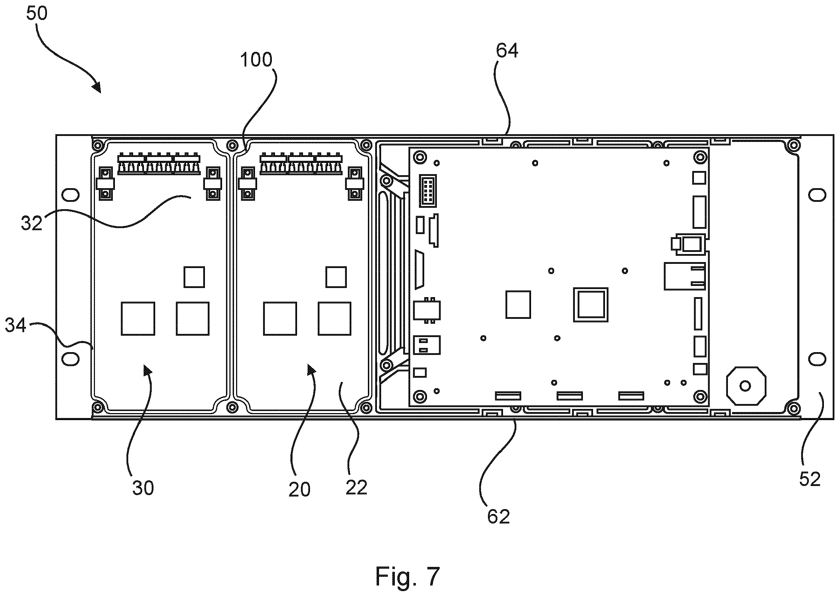

In der Figur 4 ist die Anordnung eines Beschriftungselementes 70 an der Gefahrenmelderzentrale 1 zu erkennen. Das Beschriftungselement 70 ist zwischen dem zweiten Bedienfeldmodul 30 und dem Anzeige- und Bedienfeld 52 angeordnet. Von einer Außenseite, die der hier gezeigten Rückseite abgewandt ist, des Anzeige- und Bedienfelds 52 kann das Beschriftungselement 70 durch die ersten Betätigungsöffnungen 54 berührt werden. In den Figuren 5-7 ist die einbaufertige Anzeige- und Bedienfeldanordnung 50 gezeigt, wobei das erste Bedienfeldmodul 20 und das zweite Bedienfeldmodul 30 an dem ersten Halterahmenabschnitt 62 und dem zweiten Halterahmenabschnitt 64 eingerastet ist.

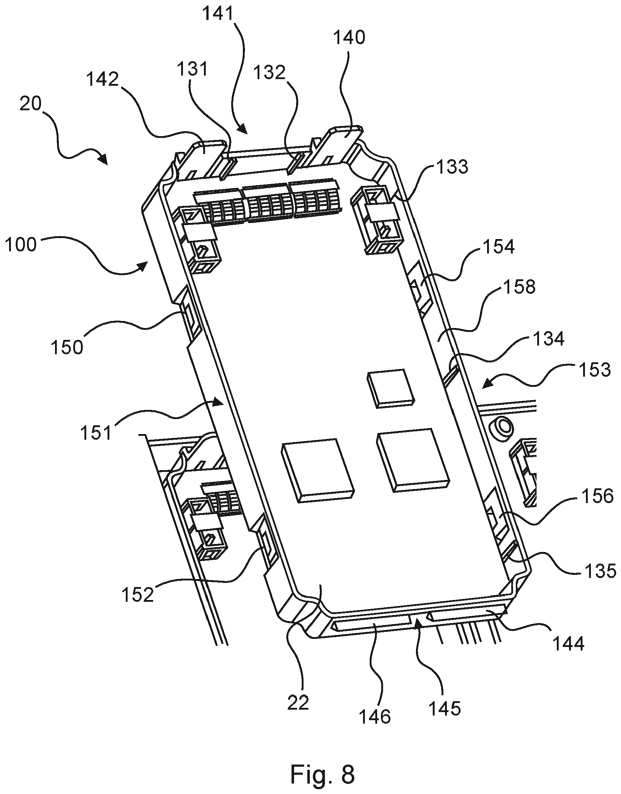

Figur 8 zeigt eine schematische, dreidimensionale Ansicht eines Bedienfeldmoduls. Die erste Trägerkomponente 100 des ersten Bedienfeldmoduls 20 erstreckt sich in vertikaler Richtung von einer oberen Trägerseite 141 zu einer unteren Trägerseite 145. Vertikal zu der Erstreckung zwischen den unteren und oberen Trägerseiten 141, 145 erstreckt sich die erste Trägerkomponente 100 von einer linken Seite 151 zu einer rechten Seite 153. Die erste Trägerkomponente 100 weist eine Grundplatte auf, auf der ein Kragen 158 angeordnet ist. Der Kragen 158 bildet Seitenwände aus und gemeinsam mit der Grundplatte einen von fünf Seiten im Wesentlichen geschlossenen Abschnitt, in den von der offenen Seite die Leiterplatte 22 anordenbar ist. An der oberen Trägerseite 141 weist die erste Trägerkomponente 100 erste Rastmittel 140, 142 auf. Die ersten Rastmittel 140, 142 sind als Rastfinger ausgebildet, die eine nach außen gerichtete Rastnase aufweisen. Die ersten Rastmittel 140, 142 sind teilweise frei von dem Kragen 158 bewegbar. An der unteren Trägerseite 145 sind zwei weitere erste Rastmittel 144, 146 angeordnet.

An der linken Seite 151 und an der rechten Seite 153 sind jeweils zwei zweite Rastmittel 150, 152, 154, 156 angeordnet. Wie in der Figur 8 ersichtlich, rastet die Leiterplatte 22 durch die zweiten Rastmittel 150, 152, 154, 156 an der ersten Trägerkomponente 100 ein. Die Trägerkomponente 100 weist zweite Fixierungen 131-135 auf, die eine spielfreie Anordnung der Leiterplatte 22 ermöglichen. Die zweiten Fixierungen 131-135 können als plastisch verformbare Vorsprünge an den Innenseiten des Kragens 158 ausgebildet sein. Die zweiten Fixierungen 131-135 sind derart angeordnet und ausgebildet, dass diese mit der Leiterplatte 22 eine Presspassung ausbilden. Darüber hinaus können die zweiten Fixierungen 131-135 als schneidende Fixierungen ausgebildet sein, die angeordnet und ausgebildet sind, sich in eine Leiterplatte zu schneiden. Die Fixierung erfolgt also durch eine plastische Verformung der Leiterplatte 22. Vorzugsweise weisen die Fixierungen 131-135 ein erstes Material auf und die Leiterplatte 22 ein zweites Material, wobei die Materialhärte des ersten Materials größer ist als die Materialhärte des zweiten Materials.

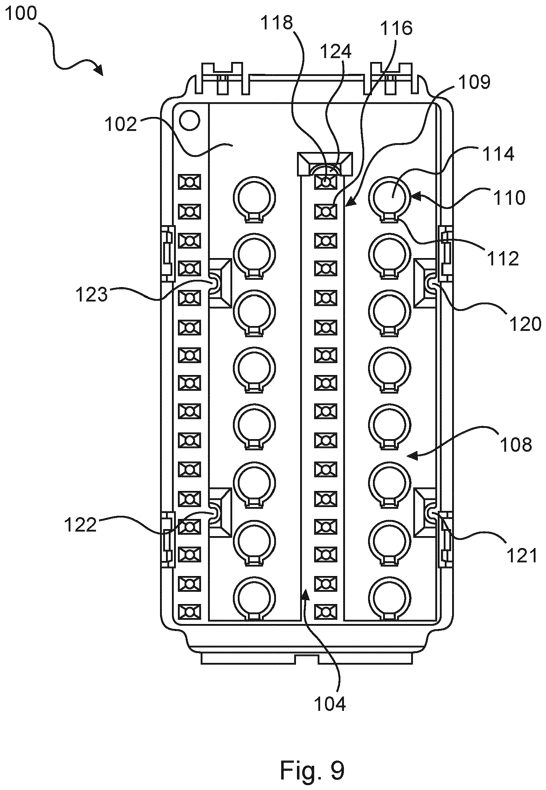

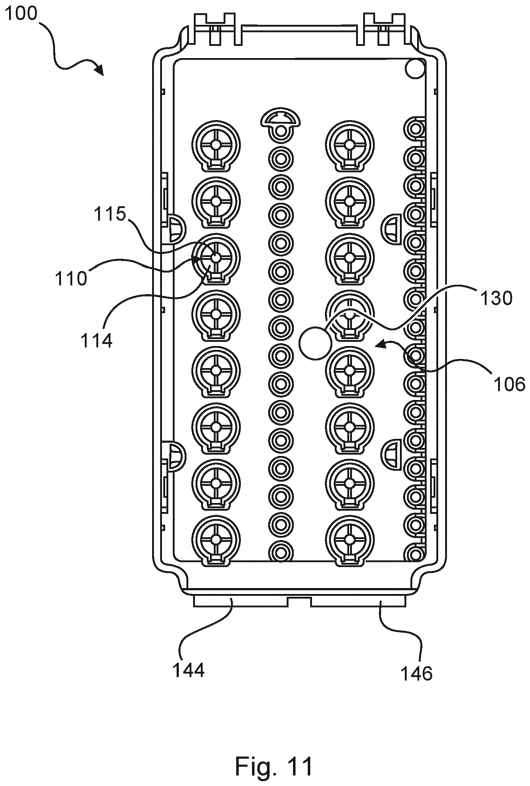

Figur 9 zeigt eine schematische, dreidimensionale Ansicht einer Vorderseite der Trägerkomponente. Die Trägerkomponente 100 weist eine Grundplatte 102 auf. Die Grundplatte 102 bildet eine Vorderseite 104 und eine in Figur 11 gezeigte Rückseite 106 aus.

Die erste Trägerkomponente 100 weist in einem Betätigungsbereich 108 insgesamt 16 Betätigungselemente auf. Darüber hinaus umfasst die Trägerkomponente 100 einen ersten Anzeigebereich 109 mit Lichtdurchgängen und einen neben dem ersten Anzeigebereich 109 angeordneten, zweiten Anzeigebereich mit Lichtdurchgängen. Jedem Betätigungselement sind zwei Lichtdurchgänge zugeordnet. Exemplarisch für die Betätigungselemente wird der Aufbau der Betätigungselemente anhand des oben rechts gezeigten Betätigungselements 110 verdeutlicht. Dem Betätigungselement 110 sind ein erster Lichtdurchgang 116 und ein zweiter Lichtdurchgang 118 zugeordnet. Das Betätigungselement 110 umfasst einen Druckabschnitt 114 und einen Halsabschnitt 112. Der Druckabschnitt 114 ist von der Grundplatte 102 der Trägerkomponente 100 durch einen Spalt beabstandet. Die Verbindung des Druckabschnitts 114 mit der Grundplatte 102 wird durch den Halsabschnitt 112 realisiert.

Die erste Trägerkomponente 100 weist darüber hinaus ein erstes Führungsmittel 120, ein zweites Führungsmittel 121, ein drittes Führungsmittel 122 und ein viertes Führungsmittel 123 auf. Die Führungsmittel 120 - 123 sind derart angeordnet, dass mittels dieser ein Beschriftungselement an der ersten Trägerkomponente 100 fixiert werden kann. Die hier gezeigten Führungsmittel 120 - 123 sind als Führungsnasen ausgebildet. An der Grundplatte 102 ist ferner ein Fixierungselement 130 angeordnet, das ein Spiel zwischen der Leiterplatte und der Trägerkomponente vermindern oder beseitigen soll.

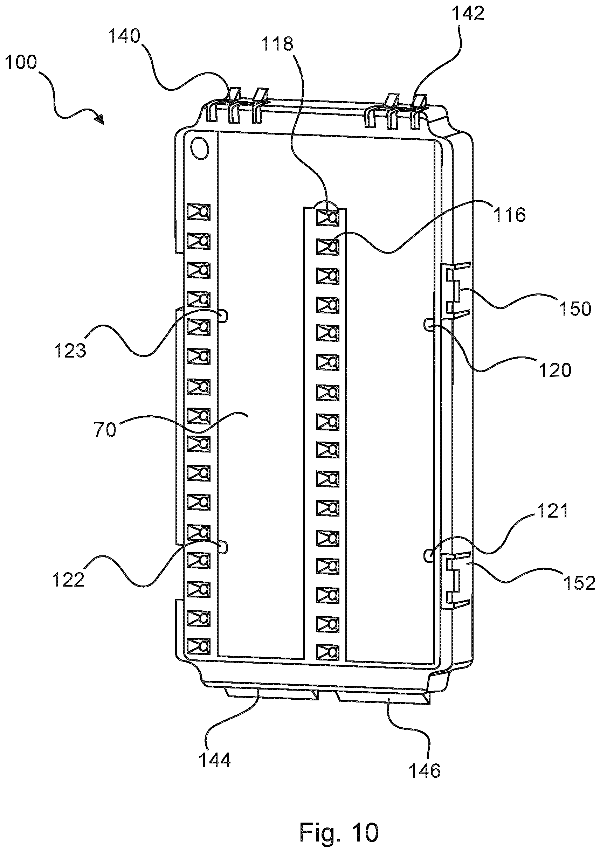

In der Figur 10 ist die Anordnung eines Beschriftungselements 70 an der ersten Trägerkomponente 100 und die Befestigung an dieser mittels der Führungsmittel 120 - 123 gezeigt.

In Figur 11 ist die Rückseite der ersten Trägerkomponente 100 gezeigt. Ferner ist die Rückseite des Betätigungselements 110 gezeigt, wobei zu sehen ist, dass auf der Rückseite des Druckabschnitts 114 ein nasenförmiges Druckelement 115 angeordnet ist.

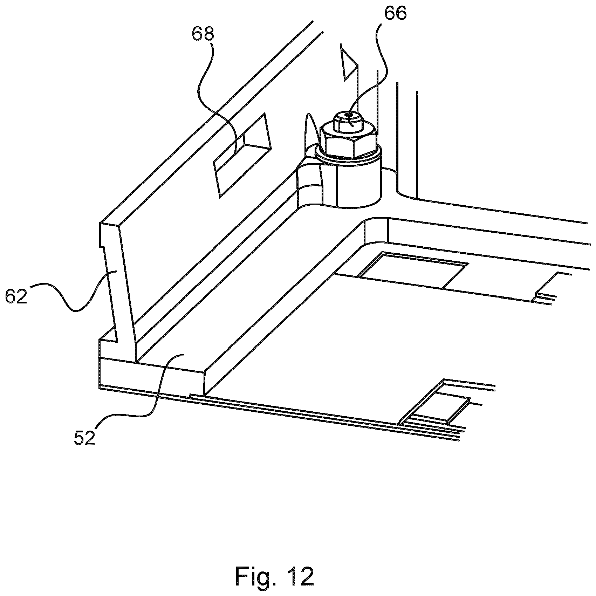

In Figur 12 ist ferner gezeigt, dass in dem ersten Halterahmenabschnitt 62 eine Befestigungsöffnung 68 angeordnet ist. Die Befestigungsöffnung 68 ist rechteckig ausgebildet, sodass hier ein Kabelbinder angeordnet werden kann. Ferner ist die Befestigung des ersten Halterahmenabschnitts 62 an dem Anzeige- und Bedienfeld 52 näher gezeigt. Diese Befestigung erfolgt in diesem exemplarischen Ausführungsbeispiel mittels eines Befestigungselements 66.

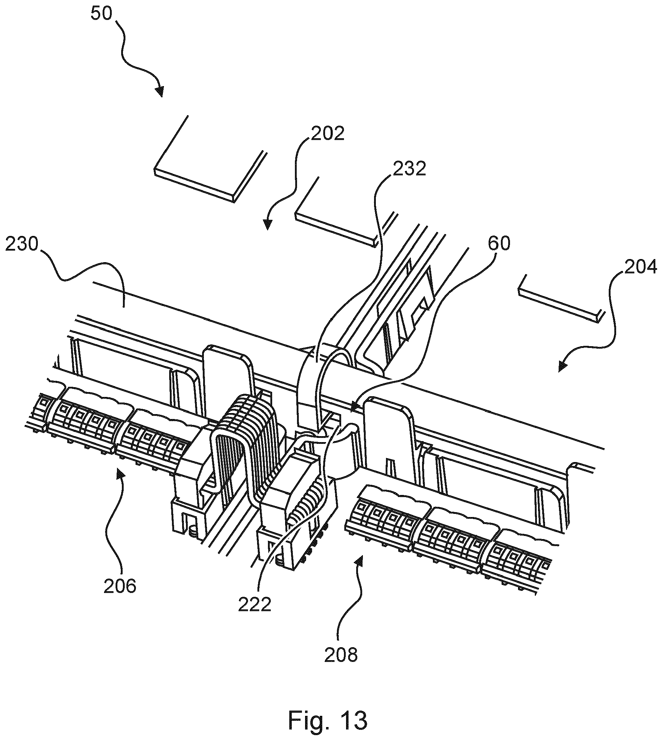

Figur 13 zeigt eine schematische, dreidimensionale Ansicht einer weiteren Anzeige- und Bedienfeldanordnung. Die Anzeige- und Bedienfeldanordnung 50 weist ein erstes Bedienfeldmodul 202, ein zweites Bedienfeldmodul 204, ein drittes Bedienfeldmodul 206 und ein viertes Bedienfeldmodul 208 auf. Die Anzeige- und Bedienfeldanordnung 50 kann auch weitere Bedienfeldmodule, beispielsweise ein fünftes Bedienfeldmodul und ein sechstes Bedienfeldmodul aufweisen. Die Bedienfeldmodule 202 - 208 sind an einem Halterahmen 60 verrastet. Der Halterahmen 60 weist eine Befestigungsöffnung 222 auf. Die Befestigungsöffnung 222 ist derart angeordnet, dass nach Befestigung der Bedienfeldmodule 202 - 208 ein Zugang besteht. Mittels der Befestigungsöffnung 222 kann ein Kabelstrang 230 mittels eines Befestigungsmittels 232, beispielsweise eines Kabelbinders, an dem Halterahmen 60 angeordnet werden

### BEZUGSZEICHEN

- 1: Gefahrenmelderzentrale
- 2: Bildschirm
- 4: erster Tastenbereich
- 6: zweiter Tastenbereich
- 20: erstes Bedienfeldmodul
- 22: erste Leiterplatte
- 30: zweites Bedienfeldmodul
- 32: zweite Leiterplatte
- 34: zweite Trägerkomponente
- 50: Anzeige- und Bedienfeldanordnung
- 52: Anzeige- und Bedienfeld
- 54: erste Betätigungsöffnungen
- 56: zweite Betätigungsöffnungen
- 60: Halterahmen
- 62: erster Halterahmenabschnitt
- 64: zweiter Halterahmenabschnitt
- 66: Befestigungselement
- 68: Befestigungsöffnung
- 70: Beschriftungselement
- 100: erste Trägerkomponente
- 102: Grundplatte
- 104: Vorderseite
- 106: Rückseite
- 108: Betätigungsbereich
- 109: Anzeigebereich
- 110: Betätigungselement
- 112: Halsabschnitt
- 114: Druckabschnitt
- 115: Druckelement
- 116: erster Lichtdurchgang
- 118: zweiter Lichtdurchgang
- 120: erstes Führungsmittel
- 121: zweites Führungsmittel
- 122: drittes Führungsmittel
- 123: viertes Führungsmittel
- 124: Anschlag
- 130: erste Fixierung
- 131, 132, 133, 134, 135: zweite Fixierung
- 140, 142, 144, 146: erste Rastmittel
- 141: obere Trägerseite
- 145: untere Trägerseite
- 150, 152, 154, 156: zweite Rastmittel
- 151: linke Seite
- 153: rechte Seite
- 158: Kragen
- 202: erstes Bedienfeldmodul
- 204: zweites Bedienfeldmodul
- 206: drittes Bedienfeldmodul
- 208: viertes Bedienfeldmodul
- 222: Befestigungsöffnung
- 230: Kabelstrang
- 232: Befestigungsmittel

## Patentansprüche

1. Trägerkomponente (34, 100) einer Anzeige- und Bedienfeldanordnung einer Gefahrenmelderzentrale (1), vorzugsweise einer Einbruch-, Brandmelder- und/oder Löschsteuerzentrale, umfassend:
- erste Rastmittel (140, 142, 144, 146) zum einrastenden Verbinden der Trägerkomponente (34, 100) mit einem auf einer Innenseite einer Wand des Gehäuses angeordneten Halterahmen (60), wobei die ersten Rastmittel (140, 142, 144, 146) derart angeordnet sind, dass eine Vorderseite (104) der Trägerkomponente (34, 100) in einem eingerasteten Zustand der Innenseite der Wand des Gehäuses zugewandt ist, und
- einen Betätigungsbereich (108), der wenigstens ein Betätigungselement (110) aufweist, das dazu ausgebildet ist, durch Krafteinwirkung aus einer Ausgangsstellung in Richtung der Rückseite (106) verformt zu werden, um eine Betätigungskraft auf die Leiterplatte (22, 32) zu übertragen, wobei das Betätigungselement (110) bei Beendigung der Krafteinwirkung in die Ausgangsstellung zurückkehrt
**gekennzeichnet durch** zweite Rastmittel (150, 152, 154, 156) zum einrastenden Verbinden mit einer Leiterplatte (22, 32), wobei die Leiterplatte (22, 32) im eingerasteten Zustand auf einer der Vorderseite (104) gegenüberliegenden Rückseite (106) der Trägerkomponente (34, 100) angeordnet ist.

2. Trägerkomponente (34, 100) nach Anspruch 1, die weiter aufweist:
- einen Anzeigebereich (109), der wenigstens einen Lichtdurchgang aufweist, der dazu ausgebildet ist, ein optisches Signal der Leiterplatte (22, 32) zu der Vorderseite (104) der Trägerkomponente (34, 100) hindurchzuführen,
und/oder
- Führungsmittel (120-123) zum Führen eines austauschbaren Beschriftungselementes (70), vorzugsweise eines als Papier oder Folie ausgebildeten Schildes, wobei die Führungsmittel (120-123) auf der Vorderseite (104) der Trägerkomponente (34, 100) angeordnet sind, derart, dass das Beschriftungselement (70) in einem eingerasteten Zustand der ersten Rastmittel (140, 142, 144, 146) zwischen der Trägerkomponente (34, 100) und der Gehäusewand angeordnet ist.

3. Trägerkomponente (34, 100) nach einem der vorstehenden Ansprüche,
wobei die Trägerkomponente (34, 100) einstückig ausgebildet ist und/oder,
wobei die Trägerkomponente (34, 100) Kunststoff aufweist oder aus Kunststoff besteht und vorzugsweise im Spritzgussverfahren hergestellt ist, und/oder
ferner aufweisend eine Aussparung für ein an der Leiterplatte (22, 32) angeordnetes Display.

4. Trägerkomponente (34, 100) nach einem der vorstehenden Ansprüche, wobei die Führungsmittel (120-123) eine Führung des Beschriftungselementes (70) in der gleichen Richtung ermöglichen, in der das Einrasten mittels der ersten Rastmittel (140, 142, 144, 146) erfolgt, und/oder
wobei die ersten Rastmittel (140, 142, 144, 146) eine an einer unteren Seite der Trägerkomponente (34, 100) ausgebildete Feder (144, 146) und einen an der oberen Seite der Trägerkomponente (34, 100) ausgebildeten Rastfinger (140, 142), der eine nach außen gerichtete Rastnase aufweist, umfasst, wobei die Feder insbesondere als federndes Einrastelement ausgebildet ist.

5. Trägerkomponente (34, 100) nach Anspruch 4, wobei eine Länge des Rastfingers (140, 142) derart ausgeführt ist, dass der Rastfinger (140, 142) in dem eingerasteten Zustand über eine Höhe des Halterahmens (60) hinausragt, und/oder
wobei der Rastfinger (140, 142) des ersten Rastmittels (140, 142, 144, 146) derart ausgebildet ist, dass ein einhändiges und werkzeugfreies Lösen der Rastverbindung möglich ist.

6. Trägerkomponente (34, 100) nach einem der vorstehenden Ansprüche, wobei die Rastverbindung des ersten Rastmittels (140, 142, 144, 146) durch ein Schwenken um eine Achse, die durch die Feder (144, 146) definiert ist, erfolgt, und/oder
wobei die zweiten Rastmittel (150, 152, 154, 156) gegenüberliegend angeordnete, an inneren Seitenflächen der Trägerkomponente (34, 100) ausgebildete, vorzugsweise je zwei an einer linken und rechten Seitenfläche ausgebildete, Rastnasen aufweisen.

7. Trägerkomponente (34, 100) nach einem der vorstehenden Ansprüche, wobei
- an wenigstens einer inneren Seitenfläche ein Fixierungselement (133, 134, 135) zur horizontalen Fixierung der in den zweiten Rastmitteln (150, 152, 154, 156) eingerasteten Leiterplatte (22, 32) vorgesehen ist, wobei vorzugsweise das Fixierungselement ausgebildet ist, die horizontale Fixierung durch eine plastische Verformung beim Einrasten der Leiterplatte (22, 32) zu ermöglichen,
und/oder
- der Betätigungsbereich (108) mehrere Betätigungselemente (110), vorzugsweise mehrere in zwei Spalten angeordnete Betätigungselemente (110), aufweist, und
- wobei eins, zwei oder mehrere oder jedes der Betätigungselemente (110) wenigstens einen zugehörigen Lichtdurchgang (116, 118) aufweist, wobei vorzugsweise ein, zwei oder mehrere oder jedes der Betätigungselemente (110) zwei zugehörige Lichtdurchgänge (116, 118) aufweist.

8. Trägerkomponente (34, 100) nach einem der vorstehenden Ansprüche, wobei
- das Betätigungselement (110) einen Halsabschnitt (112) und einen sich daran anschließenden Druckabschnitt (114) mit größerem Querschnitt aufweist,
- wobei sich der Halsabschnitt (112) bei Druckausübung auf den Druckabschnitt (114) elastisch verformt, wobei der Druckabschnitt (114) vorzugsweise eine gewölbte, insbesondere in Richtung der Vorderseite (104) konvex gewölbte, Form aufweist.

9. Trägerkomponente (34, 100) nach einem der vorstehenden Ansprüche, wobei
- die Führungsmittel (120-123) mehrere, im Wesentlichen parallel zu der Vorderseite (104) der Trägerkomponente (34, 100) angeordnete Führungsnasen aufweisen,
- wobei wenigstens eine der Führungsnasen einen Anschlag (124) entgegen der Führungsrichtung definiert, und
- vorzugsweise eine Unterseite wenigstens einer Führungsnase in horizontaler Richtung eine geringere Beabstandung von der Rückseite (106) aufweist als die Vorderseite (104) von der Rückseite (106).

10. Bedienfeldmodul (20, 30) einer Gefahrenmelderzentrale (1), umfassend eine Trägerkomponente (34, 100) nach einem der vorstehenden Ansprüche 1-9 und eine in die zweiten Rastmittel (150, 152, 154, 156) eingerastete Leiterplatte (22, 32).

11. Anzeige- und Bedienfeldanordnung (50) einer Gefahrenmelderzentrale (1), umfassend:
- ein Anzeige- und Bedienfeld (52),
- einen Halterahmen (60), und
- wenigstens ein Bedienfeldmodul (20, 30) nach Anspruch 10.

12. Anzeige- und Bedienfeldanordnung (50) nach Anspruch 11, wobei der Halterahmen (60) auf einer Innenseite des Anzeige- und Bedienfelds (52) reversibel befestigt, vorzugsweise verschraubt ist, und/oder
der Halterahmen (60) eine Befestigungsöffnung (222) zur Anordnung von Befestigungsmitteln (232) für einen Kabelstrang (230), vorzugsweise Kabelbaum, aufweist, und/oder
wobei das Anzeige- und Bedienfeld (52) eine Folie aufweist, wobei die Folie auf einer Vorderseite oder einer Hinterseite des Anzeige- und Bedienfelds (52) angeordnet ist, wobei vorzugsweise ein Abschnitt des Beschriftungselements (70), der an eine obere Kante des Beschriftungselements (70) angrenzt, zwischen der Folie und dem Anzeige- und Bedienfeld (52) angeordnet ist.

13. Gehäuse einer Gefahrenmelderzentrale (1), umfassend:
- einen Gehäuseabschnitt mit mindestens einer Anzeige- und Bedienfeldanordnung (50) nach einem der Ansprüche 11-12.

14. Gefahrenmelderzentrale (1), vorzugsweise Einbruch-, Brandmelder- und/oder Löschsteuerzentrale, mit einem Gehäuse nach Anspruch 13, wobei
- in jeder der Trägerkomponenten (34, 100) eine zugehörige Leiterplatte (22, 32) eingerastet ist, und
- Leiterplatten (22, 32) nebeneinander angeordneter Trägerkomponenten (34, 100) direkt mit einem Verbindungskabel (230) zur Datenübertragung verbunden sind.

15. Gefahrenmelderzentrale (1) nach Anspruch 14, wobei jede der Leiterplatten (22, 32) dazu ausgebildet ist, den Zustand mehrerer signalleitend mit der Gefahrenmelderzentrale verbundenen Peripheriegeräten, vorzugsweise mehrerer Meldergruppen einer Brandmelder- und/oder Löschsteuerzentrale, anzuzeigen,
wobei die Bezeichnung der Meldergruppen oder Komponenten vorzugsweise mittels der Beschriftungselemente (70) der jeweiligen Trägerkomponenten (34, 100) erfolgt.

## Claims

1. A support component (34, 100) of a display and control panel arrangement of a hazard alarm control center (1), preferably a burglar alarm, fire alarm, and/or fire extinguishing control center, comprising:
- first latching means (140, 142, 144, 146) for connecting and latching the support component (34, 100) to a mounting frame (60) disposed on an inner side of a wall of a housing, the first latching means (140, 142, 144, 146) being disposed such that a front side (104) of the support component (34, 100) faces the inner side of the wall of the housing in a latched state,
- an actuation area (108) comprising at least one actuating element (110) implemented for being deformed by a force from a starting position in the direction toward the back side (106) in order to transmit an actuating force to the circuit board (22, 32), the actuating element (110) returning to the starting position when the force stops acting,
**characterized by** second latching means (150, 152, 154, 156) for connecting and latching to a circuit board (22, 32), the circuit board (22, 32) being disposed on a back side (106) of the support component (34, 100) opposite the front side (104) in the latched state,

2. The support component (34, 100) according to claim 1, further comprising:
- a display area (109) comprising at least one light passage implemented for passing through an optical signal of the circuit board (22, 32) to the front side (104) of the support component (34, 100),
and/or
- guides (120-123) for guiding an interchangeable label element (70), preferably a tag made of paper or film, wherein the guides (120-123) are disposed on the front side (104) of the support component (34, 100) such that the label element (70) is disposed between the support component (34, 100) and the housing wall in the latched state of the first latching means (140, 142, 144, 146).

3. The support component (34, 100) according to any one of the preceding claims, wherein the support component (34, 100) is implemented as a single piece and/or,
wherein the support component (34, 100) comprises plastic or is made of plastic and is preferably produced in an injection molding process, and/or
further comprising a cutout for a display disposed on the circuit board (22, 32).

4. The support component (34, 100) according to any one of the preceding claims, wherein the guides (120-123) enable guiding of the label element (70) in the same direction in which the latching takes place by means of the first latching means (140, 142, 144, 146), and/or
wherein the first latching means (140, 142, 144, 146) comprise a spring (144, 146) on a bottom side of the support component (34, 100) and a latching finger (140, 142) implemented on the top side of the support component (34, 100) and comprising a latching lug facing outward, wherein the spring is particularly implemented as a spring-loaded latching element.

5. The support component (34, 100) according to claim 7, wherein a length of the latching finger (140, 142) is implemented such that the latching finger (140, 142) protrudes above a height of the mounting frame (60) in the latched state, and/or
wherein the latching finger (140, 142) of the first latching means (140, 142, 144, 146) is implemented such that the latching connection can be released using one hand and no tools.

6. The support component (34, 100) according to any one of the preceding claims, wherein the latching connection of the first latching means (140, 142, 144, 146) takes place by pivoting about an axis defined by the spring (144, 146), and/or
wherein the second latching means (150, 152, 154, 156) comprise latching lugs disposed opposite implemented on inner lateral surfaces of the support component (34, 100), preferably two each implemented on a left and right lateral surface.

7. The support component (34, 100) according to any one of the preceding claims, wherein
- a locating element (133, 134, 135) for horizontally locating the circuit board (22, 32) latched in the second latching means (150, 152, 154, 156) is present on at least one inner lateral surface, wherein the locating element is preferably implemented for enabling horizontal locating by means of plastic deformation when latching the circuit board (22, 32),
and/or
- the actuation area (108) comprises a plurality of actuating elements (110), preferably a plurality of actuating elements (110) disposed in two columns, and
- wherein one, two, or more or every actuating element (110) comprises at least one associated light passage (116, 118), wherein preferably one, two, or more or every actuating element (110) comprises two associated light passages (116, 118).

8. The support component (34, 100) according to any one of the preceding claims, wherein
- the actuating element (110) comprises a neck segment (112) and an adjacent press segment (114) having a larger cross section,
- wherein the neck segment (112) deforms elastically when the press segment (114) is pressed, wherein preferably the press segment (114) comprises a curved shape, preferably convexly curved in the direction of the front side (104).

9. The support component (34, 100) according to any one of the preceding claims, wherein
- the guides (120-123) comprise a plurality of guide lugs disposed substantially parallel to the front side (104) of the support component (34, 100),
- wherein at least one of the guide lugs defines a stop (124) opposite the guide direction, and
- preferably a bottom side of at least one guide lug comprises a lesser distance in the horizontal direction from the back side (106) than the front side (104) from the back side (106).

10. A control panel module (20, 30) of a hazard alarm control center (1), comprising a support component (34, 100) according to any one of the preceding claims 1-18 and a circuit board (22, 32) latched into the second latching means (150, 152, 154, 156).

11. A display and control panel arrangement (50) of a hazard alarm control center (1), comprising:
- a display and control panel (52),
- a mounting frame (60), and
- at least one control panel module (20, 30) according to claim 19.

12. The display and control panel arrangement (50) according to claim 20, wherein the mounting frame (60) is reversibly attached, preferably screwed, to an inner side of the display and control panel (52), and/or
the mounting frame (60) comprises a mounting opening (222) for disposing mounting means (232) for a cable strand (230), preferably a cable harness, and/or
wherein the display and control panel (52) comprises a film, wherein the film is disposed on a front side or a back side of the display and control panel (52), wherein a segment of the label element (70) adjacent to a top edge of the label element (70) is preferably disposed between the film and the display and control panel (52).

13. A housing of a hazard alarm control center (1), comprising:
- a housing segment having at least one display and control panel arrangement (50) according to any one of the claims 20-22.

14. A hazard alarm control center (1), preferably a burglar alarm, fire alarm, and/or fire extinguishing control center, having a housing according to claim 23, wherein
- an associated circuit board (22, 32) is latched into each of the support components (34, 100), and
- circuit boards (22, 32) of support components (34, 100) disposed adjacent to each other are directly connected by means of a connecting cable (230) for transmitting data.

15. The hazard alarm control center (1) according to claim 24, wherein each of the circuit boards (22, 32) is implemented for indicating the state of a plurality of peripheral devices connected to the hazard alarm control center for conducting signals, preferably a plurality of sensor groups of a fire alarm and/or fire extinguishing control center, wherein the sensor groups or components are preferably labeled by means of the label elements (70) of the corresponding support components (34, 100).

## Revendications

1. Composant de support (34, 100) d'un ensemble de champ d'affichage et de commande d'une centrale d'alarme de dangers (1), de préférence d'une centrale d'alarme d'infraction, d'incendie et/ou de commande d'extinction, comprenant :
- des premiers moyens d'enclenchement (140, 142, 144, 146) destinés à raccorder par encliquetage les composants de support (34, 100) à un cadre de maintien (60) disposé sur un côté intérieur d'une paroi du boîtier, dans lequel les premiers moyens d'enclenchement (140, 142, 144, 146) sont disposés de telle manière qu'un côté avant (104) du composant de support (34, 100) est tourné, dans un état encliqueté, vers le côté intérieur de la paroi du boîtier, et
- une zone d'actionnement (108), qui présente au moins un élément d'actionnement (110) qui est réalisé pour être déformé sous l'effet d'une force en direction du côté arrière (106) depuis une position de départ pour transmettre une force d'actionnement sur la carte de circuits imprimés (22, 32), dans lequel l'élément d'actionnement (110) revient dans la position de départ une fois l'effet de la force terminé,
**caractérisé par** des deuxièmes moyens d'enclenchement (150, 152, 154, 156) destinés à être raccordés par encliquetage à une carte de circuits imprimés (22, 32), dans lequel la carte de circuits imprimés (22, 32) est disposée, dans l'état encliqueté, sur un côté arrière (106), faisant face au côté avant (104), du composant de support (34, 100).

2. Composant de support (34, 100) selon la revendication 1, qui présente par ailleurs :
- une zone d'affichage (109), qui présente au moins un passage de lumière qui est réalisé pour guider de part en part un signal optique de la carte de circuits imprimés (22, 32) en direction du côté avant (104) du composant de support (34, 100),
et/ou
- des moyens de guidage (120 - 123) permettant de guider un élément d'inscription (70) interchangeable, de préférence un panneau réalisé sous la forme de papier ou d'un film, dans lequel les moyens de guidage (120 - 123) sont disposés sur le côté avant (104) du composant de support (34, 100) de telle manière que l'élément d'inscription (70) est disposé dans un état encliqueté des premiers moyens d'enclenchement (140, 142, 144, 146), entre le composant de support (34, 100) et la paroi de boîtier.

3. Composant de support (34, 100) selon l'une quelconque des revendications précédentes,
dans lequel le composant de support (34, 100) est réalisé d'un seul tenant et/ou,
dans lequel le composant de support (34, 100) présente de la matière plastique ou est constitué de matière plastique et est fabriqué de préférence dans le procédé de moulage par injection, et/ou
présentant en outre un évidement pour un écran disposé sur la carte de circuits imprimés (22, 32).

4. Composant de support (34, 100) selon l'une quelconque des revendications précédentes, dans lequel les moyens de guidage (120 - 123) permettent un guidage de l'élément d'inscription (70) dans la même direction que celle dans laquelle l'encliquetage est effectué au moyen des premiers moyens d'enclenchement (140, 142, 144, 146), et/ou
dans lequel les premiers moyens d'enclenchement (140, 142, 144, 146) comprennent un ressort (144, 146) réalisé sur un côté inférieur du composant de support (34, 100) et un doigt d'enclenchement (140, 142) réalisé sur le côté supérieur du composant de support (34, 100), qui présente un ergot d'enclenchement dirigé vers l'extérieur, dans lequel le ressort est réalisé en particulier en tant qu'élément d'encliquetage sur ressorts.

5. Composant de support (34, 100) selon la revendication 4, dans lequel une longueur du doigt d'enclenchement (140, 142) est réalisée de telle manière que le doigt d'enclenchement (140, 142) dépasse dans l'état encliqueté d'une hauteur du cadre de maintien (60), et/ou
dans lequel le doigt d'enclenchement (140, 142) du premier moyen d'enclenchement (140, 142, 144, 146) est réalisé qu'un desserrage d'une main et sans outil du raccordement par enclenchement est possible.

6. Composant de support (34, 100) selon l'une quelconque des revendications précédentes, dans lequel le raccordement par enclenchement du premier moyen d'enclenchement (140, 142, 144, 146) est effectué par un pivotement autour d'un axe qui est défini par le ressort (144, 146), et/ou
dans lequel les deuxièmes moyens d'enclenchement (150, 152, 154, 156) présentent des ergots d'enclenchement disposés en vis-à-vis, réalisés sur des faces latérales intérieures du composant de support (34, 100), de préférence respectivement deux ergots d'enclenchement réalisés sur une face latérale gauche et une face latérale droite.

7. Composant de support (34, 100) selon l'une quelconque des revendications précédentes, dans lequel
- un élément de blocage (133, 134, 135) permettant de bloquer de manière horizontale la carte de circuits imprimés (22, 32) encliquetée dans les deuxièmes moyens d'enclenchement (150, 152, 154, 156) est prévu sur au moins une face latérale intérieure, dans lequel de préférence l'élément de blocage est réalisé pour permettre le blocage horizontal par une déformation plastique lors de l'encliquetage de la carte de circuits imprimés (22, 32),
et/ou
- la zone d'actionnement (108) présente plusieurs éléments d'actionnement (110), de préférence plusieurs éléments d'actionnement (110) disposés dans deux colonnes, et
- dans lequel un, deux ou plusieurs ou chacun des éléments d'actionnement (110) présente au moins un passage de lumière (116, 118) associé, dans lequel de préférence un, deux ou plusieurs ou chacun des éléments d'actionnement (110) présente deux passages de lumière (116, 118) associés.

8. Composant de support (34, 100) selon l'une quelconque des revendications précédentes, dans lequel
- l'élément d'actionnement (110) présente une section de col (112) et une section de pression (114), s'y raccordant, présentant une section transversale plus grande,
- dans lequel la section de col (112) se déforme élastiquement lors de l'application d'une pression sur la section de pression (114), dans lequel la section de pression (114) présente de préférence une forme bombée, en particulier bombée de manière convexe en direction du côté avant (104).

9. Composant de support (34, 100) selon l'une quelconque des revendications précédentes, dans lequel
- les moyens de guidage (120 - 123) présentent plusieurs ergots de guidage disposés de manière sensiblement parallèle par rapport au côté avant (104) du composant de support (34, 100),
- dans lequel au moins un des ergots de guidage définit une butée (124) dans le sens opposé à la direction de guidage, et
- de préférence un côté inférieur d'au moins un ergot de guidage présente, dans une direction horizontale, un espacement par rapport au côté arrière (106) plus petit que l'espacement du côté avant (104) par rapport au côté arrière (106).

10. Module de champ de commande (20, 30) d'une centrale d'alarme de dangers (1), comprenant un composant de support (34, 100) selon l'une quelconque des revendications 1 - 9 et une carte de circuits imprimés (22, 32) encliquetée dans les deuxièmes moyens d'enclenchement (150, 152, 154, 156).

11. Ensemble de champ d'affichage et de commande (50) d'une centrale d'alarme de dangers (1), comprenant :
- un champ d'affichage et de commande (52),
- un cadre de maintien (60), et
- au moins un module de champ de commande (20, 30) selon la revendication 10.

12. Ensemble de champ d'affichage et de commande (50) selon la revendication 11, dans lequel le cadre de maintien (60) est fixé de manière réversible, de préférence est vissé, sur un côté intérieur du champ d'affichage et de commande (52), et/ou
le cadre de maintien (60) présente une ouverture de fixation (222) permettant de disposer des moyens de fixation (232) pour un câblage (230), de préférence un faisceau de câbles,
et/ou
dans lequel le champ d'affichage et de commande (52) présente un film, dans lequel le film est disposé sur un côté avant ou un côté arrière du champ d'affichage et de commande (52), dans lequel de préférence une section de l'élément d'inscription (70), qui jouxte un bord supérieur de l'élément d'inscription (70), est disposée entre le film et le champ d'affichage et de commande (52) .

13. Boîtier d'une centrale d'alarme de dangers (1), comprenant :
- une section de boîtier avec au moins un ensemble de champ d'affichage et de commande (50) selon l'une quelconque des revendications 11 - 12.

14. Centrale d'alarme de dangers (1), de préférence centrale d'alarme d'infraction, d'incendie et/ou de commande d'extinction, avec un boîtier selon la revendication 13, dans laquelle
- une carte de circuits imprimés (22, 32) associée est encliquetée dans chacun des composants de support (34, 100), et
- des cartes de circuits imprimés (22, 32) de composants de support (34, 100) disposés côte à côte sont directement raccordées à un câble de raccordement (230) pour la transmission de données.

15. Centrale d'alarme de dangers (1) selon la revendication 14, dans laquelle chacune des cartes de circuits imprimés (22, 32) est réalisée pour indiquer l'état de plusieurs appareils périphériques raccordés avec acheminement de signaux à la centrale d'alarme de dangers, de préférence de plusieurs groupes d'alarmes d'une centrale d'alarme d'incendie et/ou de commande d'extinction,
dans laquelle la désignation des groupes d'alarmes ou composants est effectuée de préférence au moyen des éléments d'inscription (70) des composants de support (34, 100) respectifs.
